(19)

Europäisches
Patentamt
European
Patent Office
Office européen
des brevets

(11) **EP 2 477 054 A1**

(12) **EUROPEAN PATENT APPLICATION**
published in accordance with Art. 153(4) EPC

(43) Date of publication:
**18.07.2012 Bulletin 2012/29**

(21) Application number: **09849090.7**

(22) Date of filing: **11.09.2009**

(51) Int Cl.:
**G02B 19/00** *(2006.01)*    **G02B 3/08** *(2006.01)*
**H02N 6/00** *(2006.01)*

(86) International application number:
**PCT/CN2009/001023**

(87) International publication number:
**WO 2011/029214 (17.03.2011 Gazette 2011/11)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(71) Applicant: **Yuan, Jianzhong**
**Xuhui District, 200030 Shanghai (CN)**

(72) Inventor: **Yuan, Jianzhong**
**Xuhui District, 200030 Shanghai (CN)**

(74) Representative: **Gulde Hengelhaupt Ziebig &
Schneider**
**Patentanwälte - Rechtsanwälte**
**Wallstrasse 58/59**
**10179 Berlin (DE)**

(54) **SOLAR CONDENSING DEVICE**

(57)    A solar condensing device includes a bracket, a light transmitting window (6), a light receiving surface (5) and at least two condensing lenses (1). The condensing lenses (1) are arranged on the bracket and around the light transmitting window (6). One surface of the condensing lens (1) is a light transmitting plane, and the other surface comprises uniformly distributed refractive prisms, the refractive surfaces (12) of which are in parallel with each other. Light beam refracted by each refractive prism is uniformly irradiated on the light receiving surface (5). The light receiving surface (5) is disposed in parallel with the light transmitting window (6). The application of this condensing device can increase at least twice the condensed light intensity.

Fig.1

## Description

## FIELD OF THE INVENTION

The present invention relates to a concentration device, in particularly, to a high power (at least triple) solar concentration device.

## BACKGROUND OF THE INVENTION

Currently, there are two ways for gathering solar energy in the solar field, one is to condense light by reflection of a planar reflection mirror and the other is to condense the light by a condensing lens.

The condensation by the reflection of a planar mirror reflects the light around a photovoltaic conversion module on the photovoltaic conversion module so as to improve the solar utilization ratio. For example, Chinese patent No. ZL 200820057277.8 discloses a triple concentration photovoltaic power generation module including a square silicon solarcell unit, four square planar reflection mirrors and a holder. The side length of the four square planar reflection mirrors is equal to that of the square silicon solarcell unit. One side of each square planar reflection mirror is connected with one side of the square silicon solarcell unit respectively, and each square planar reflection mirror is arranged at a 120-degree relative to the square silicon solarcell unit. This geometric relation between the four square planar reflection mirrors and the square silicon solarcell unit is fixed by the holder.

Since each square planar reflection mirror is arranged at a 120-degree relative to the square silicon solarcell unit, and the side length of the square planar reflection mirror is equal to that of one side of the square silicon solarcell unit, when a sunlight is perpendicularly incident on the square silicon solarcell unit, the projection area of a square planar reflection mirror on the surface of the square silicon solarcell unit is right half of the area of the square silicon solarcell unit. Thus the light intensity of the square silicon solarcell unit is triple of that without the planar reflection mirrors.

The condensation by condensing lenses condenses the light around a solarcell unit on the solarcell unit by convex lenses or Fresnel lenses. Such technical embodiments are published in Chinese patent application No. 94112957.8 with a title of "large area transmission focusing solar collector" and Chinese patent application No. 200610117470.1 with a title of "a solar device with a parallel refractive lens".

The large area transmission focusing solar collector is a sector or circular structure merged with sector solar collecting sheets. The sector solar collecting sheet is made of a transparent material having a refractive index of more than one and parallel upper and lower surfaces, wherein concentric arc stripes are carved on the lower surface, and the longitudinal section of the collecting sheet has a serrated structure.

Since the longitudinal section of the collecting sheet has a serrated structure, when sunlight is perpendicularly incident on the collector, sunlight is condensed to a point or a line, which is suitable for the solar device having tubular or spherical light receiving surface. However, for planar mono-crystalline silicon solarcell currently produced in a large scale, this will result in greatly deterioration of the operation conditions due to the nonuniform light intensity on the surface of the cell.

To solve the above problem, Chinese patent application No. 200610117470.1 provides a solar device with parallel refractive lenses which is an improved embodiment. The solar device with parallel refractive lenses consists of parallel refractive lenses, a sunlight tracking apparatus, a light concentration solar device and a house. The refractive lenses consist of multiple refractive lens sheets having a planar refractive surface, which are disposed on a glass plate and arranged in a serrated structure. Each of the refractive lens sheets has two nonparallel surfaces (a sloped refractive surface and a planar refractive surface) and the included angles between two refractive surfaces of the adjacent refractive lens sheets are different from each other.

In the above embodiment, sunlight is refracted to the solarcell by the refractive lenses. When the incident angle of sunlight changes, the solarcell moves up and down tracking on the collecting surface, such that the sunlight is always incident on the solarcell to convert the solar energy into electric power.

In the above embodiment, however, to ensure that the projection areas of the refractive light from the refractive lenses on the collecting plane accurately overlaps together and coincides with the projection of the light emitted from the middle of the glass plate where there is no lens, the included angles between two refractive surfaces of each refractive lens are different from the other, which is difficult in industrial manufacture.

## SUMMARY OF THE INVENTION

The object of the present invention is to provide a solar concentration device, which can condense the solar energy with a high concentration efficiency of at least triple and has a simple structure such that it is easy to manufacture.

To achieve the above object, the present technical embodiment is:

a solar concentration device, includes a bracket, a light transmitting window, a light receiving surface and at least two condensing lenses. The condensing lenses are arranged on the bracket and distributed around the light transmitting window. One surface of the condensing lens is a light transmitting plane, and the other surface comprises uniformly distributed refractive prisms, the refractive surfaces of which are in parallel with each. Light beam refracted by each refractive prism is uniformly irradiated on the light receiving surface. Meanwhile, the light receiving surface is disposed in parallel with the light transmitting window.

The included angle β between the refractive surface of the refractive prism and the light transmitting plane, as well as the refraction angle α and the refractive index n of the refractive prism meet the following equation: $nsin\beta = \sin \alpha$.

The distance H between the condensing lens and the light receiving surface and the side length L of the light receiving surface meet the following equation:

$$H = \frac{L}{tg(\alpha - \beta)},$$ in which α is the refraction angle of the refractive prism, β is the included angle between the refractive surface of the refractive prism and the light transmitting plane.

The distance H between the condensing lens and the light receiving surface and the side length L of the light receiving surface meet the following equation:

$$H = \frac{\sqrt{2}L}{tg(\alpha'-\beta')},$$ in which α' is the refraction angle of the refractive prism, β' is the included angle between the refractive surface of the refractive prism and the light transmitting plane.

The present invention has the following advantages.

1. Since the present concentration device includes at least two lens, the light irradiating on each condensing lens is refracted to the light receiving surface by the uniformly distributed refractive prisms. When the areas of the light receiving surface, the light transmitting window and the condensing lens are equal, the light intensity received on the light receiving surface is at least triple of that without the concentration device of the present invention. That is, the light intensity on the light receiving surface is "the number of the lens +1" times as much as that without the concentration device of the present invention. If the number of the lens is four, the obtained light intensity on the light receiving surface is five times; if the number of the lens is eight, the obtained light intensity on the light receiving surface is nine times. Therefore, the present concentration device has a high concentration efficiency and is an ideal solar concentration device.

2. Because the distance between the condensing lens and the light receiving surface and the side length of the light receiving surface has the above relation, it not only ensures that all the sunlight is refracted on the light receiving surface, but also the distance can be adjusted easily.

3. The present concentration device has a simple structure so that it is easy to manufacture with a low cost, and thus is suitable for production in a large scale and application in solar cell, solar water heater or other solar devices.

**BRIEF DESCRIPTION OF THE DRAWINGS**

Fig.1 shows a structural schematic view illustrating the concentration device of one embodiment of the present invention;

Fig.2 shows an upward view of the condensing lens and the light transmitting window in figure 1;

Figure 3 shows a structural schematic view illustrating one example of the condensing lens in figure 1;

Fig.4 shows a schematic view illustrating the distance between the condensing lens and the light receiving surface in figure 1;

Fig.5 shows a structural top view illustrating the solar concentration device of another embodiment of the present invention;

Fig.6 is the upward view of figure 5;

Fig.7 shows a schematic view illustrating the distance between the condensing lens and the light receiving surface in figure 5.

**DETAILED DESCRIPTION OF EXEMPLARY EMBODIMENTS**

Next, the structural features of the present invention will be described in detail referring to the drawings.

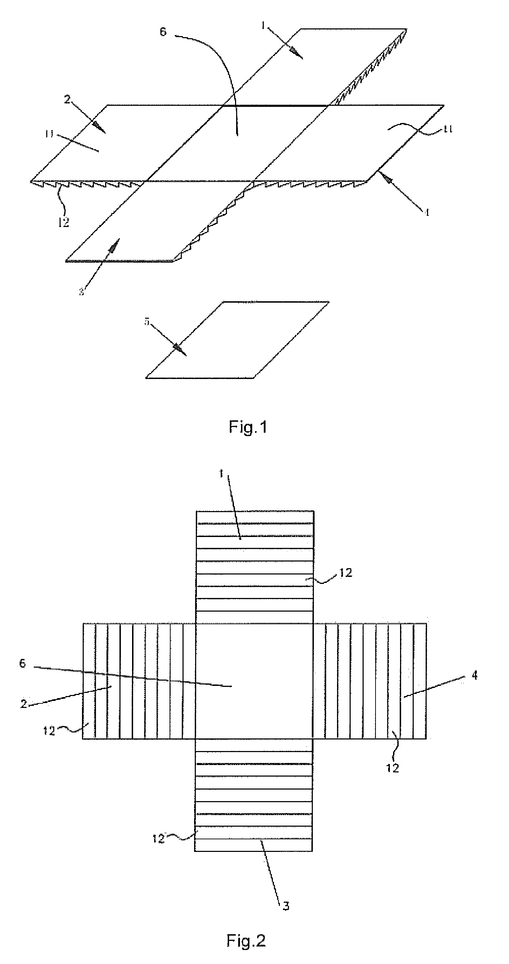

Figure 1 is a structural schematic view illustrating the solar concentration device of one embodiment of the present invention. As shown in figure 1, in this embodiment, the solar concentration device includes four lens 1, 2, 3, 4 with same structure, a bracket (not shown in figure 1) supporting the above four lens 1, 2, 3, 4, a light receiving surface 5 and a light transmitting window 6. The light receiving surface 5 is parallelly disposed right below the light transmitting window 6 (in the direction of the light beam through the light transmitting window 6). In figure 1, 11 is the light receiving surface of the condensing lens, and 12 is the parallel refractive surfaces of the refractive prisms that are uniformly distributed on the other side of the condensing lens. In addition, the lens may be two lens distributed symmetrically relative to the light transmitting window 6, for example, lens 1, 3 or lens 2, 4; or distributed asymmetrically, for example, lens 1, 2 or condensing lens 3, 4; the lens may also be three lens distributed relative to the light transmitting window 6, for example, lens 1, 2, 3, lens 2, 3, 4 or lens 1, 2, 4.

Figure 2 is the upward view of the condensing lens and the light transmitting window in figure 1. As shown in figure 2, lens 1, 2, 3, 4 have an equal side length to that of the light transmitting window 6. The four lens 1, 2, 3, 4 are uniformly distributed around the light transmitting window 6, locating in a same plane to form a concentrating array. The prisms of the condensing lens 2 are arranged at 90-degree relative to those of the condensing lens 1, the prisms of the condensing lens 3 are arranged at 90-degree relative to those of condensing lens 2, and the prisms of the condensing lens 4 are arranged at 90-degree relative to those of condensing lens 3, so that condensing lens 1 and condensing lens 3 are distributed symmetrically relative to the light transmitting window 6, and condensing lens 2 and condensing lens 4 are distributed symmetrically relative to the light transmitting window 6.

When the present concentration device is applied in, for example, solar cell, solar water heater or other devices using the solar energy, the light receiving surface 5 is the light absorbing surface thereof.

The light transmitting window 6 serves to enable the sunlight to irradiate the light receiving surface 5 directly. The light transmitting window 6 may be an open window(empty) or equipped with a transparent plate.

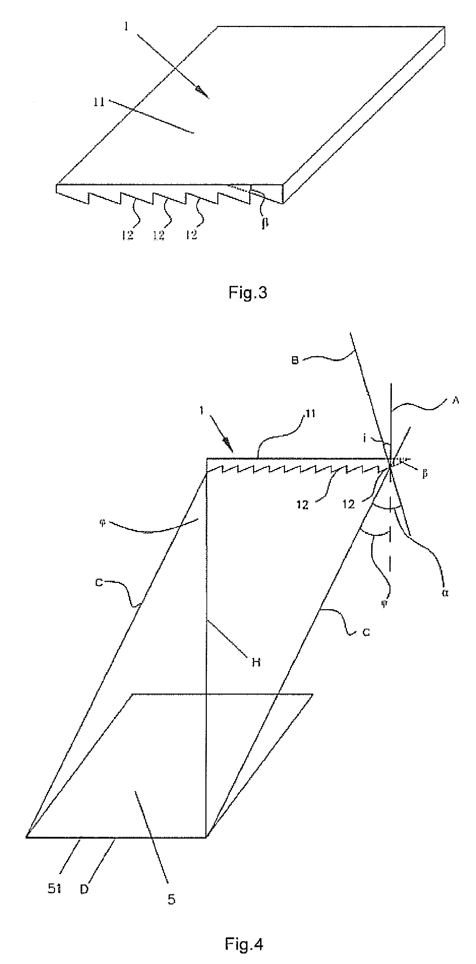

Figure 3 is a structural schematic view illustrating one example of the condensing lens in figure 1. As shown in figure 2, the material of the lens 1, 2, 3, 4 in this example is glass or organic glass. The lens 1, 2, 3, 4 are each square, in which one side thereof is a light transmitting plane 11 and the other side thereof is arranged with uniformly distributed refractive prism with parallel refractive surfaces 12, and the refractive surface 12 and light transmitting plane 11 has an included angle β.

In the structures shown in figures 1-3, since the light transmitting window 6 and the lens 1, 2, 3, 4 are located in a same plane, when sunlight perpendicularly irradiates from the light transmitting window 6 on the light receiving surface 5, it also perpendicularly irradiates on the light transmitting planes 11 of the lens 1, 2, 3, 4 and in an incident angle i on the refractive surface 12. In this case, the incident angle i is equal to the included angle β between the refractive surface 12 and the light transmitting plane 12. Since the refractive surfaces 12 of the prisms of each of lens 1, 2, 3, 4 are in parallel, the prisms of the condensing lens 2 are arranged at 90-degree relative to those of the condensing lens 1, the prisms of the condensing lens 3 are arranged at 90-degree relative to those of the condensing lens 2, and the prisms of the condensing lens 4 are arranged at 90-degree relative to those of the condensing lens 3, all the light beams will be refracted to the light receiving surface 5 after they transmit out from the refractive surface 12 of the refractive prisms of the lens 1, 2, 3, 4. Further, since the lens 1, 2, 3, 4 have an equal side length to those of the light receiving surface 5 and the light transmitting window 6, the lens 1, 2, 3, 4 can refract four times sunlight as much as that on the surface of the light receiving surface 5 to the light receiving surface 5. Thereby, in this example, the condensing intensity of the present concentration device is five times as much as that without the concentration device. Moreover, because the refractive surfaces 12 are in parallel with each other, the refracted sunlight via the refractive surfaces 12 can irradiate parallelly the light receiving surface 5 so that the light can irradiate uniformly the light receiving surface 5.

Of course, the present solar concentration device may also be equipped on a tracker so that the sunlight can perpendicularly irradiate the lens 1, 2, 3, 4 all the time.

Figure 4 is a schematic view illustrating the distance between the condensing lens and the light receiving surface in figure 1. As shown in figure 4, in order to make all the light transmitted through the refractive surface 12 irradiate uniformly the light receiving surface 5, the distance H between the lens 1, 2, 3, 4 and the light receiving surface 5 meets the following equation:

$$H = \dfrac{L}{\operatorname{tg}(\alpha - \beta)}$$ wherein β is the included angle between the refractive surface 12 and the light transmitting plane 11, and equal to the incident angle; α is the refraction angle, wherein the refraction angle α and the included angle β follow the relation below: $n\sin\beta = \sin\alpha$ .Next, the above equation will be explained in detail by taking condensing lens 1 as an example. As shown in figure 4, A is the incident light, B is the normal line and C is the refractive light. Because the incident light A perpendicularly irradiates the light transmitting plane 11, the incident angle of the incident light A is equal to the included angle β between the refractive surface 12 and the light transmitting plane 11, thus α minus β (i.e., α-β) is equal to the included angle φ between the refractive light C and the extension line of the incident light A. Since the incident light A perpendicularly irradiates the light transmitting plane 11 and the refractive lights C are in parallel with each other, and thus tg (α - β) = D/$_H$ Since the side of the condensing lens 1 is in contact with the side of the light transmitting window 6, and the light receiving surface 5 is parallelly placed right below the light transmitting window 6, when the condensing lens is square, its side length D is equal to the side length 51 of the light receiving surface. If side length 51 is replaced by L, D is equal to L (i.e, D=L), so tg(α - β ) = L/$_H$, thus H = L/$_{tg(\alpha - \beta)}$. The distance between the condensing lens 1 and the light receiving surface 5 can be adjusted via the above equation to ensure that the light irradiating the condensing lens 1 can be completely refracted to the light receiving surface 5.

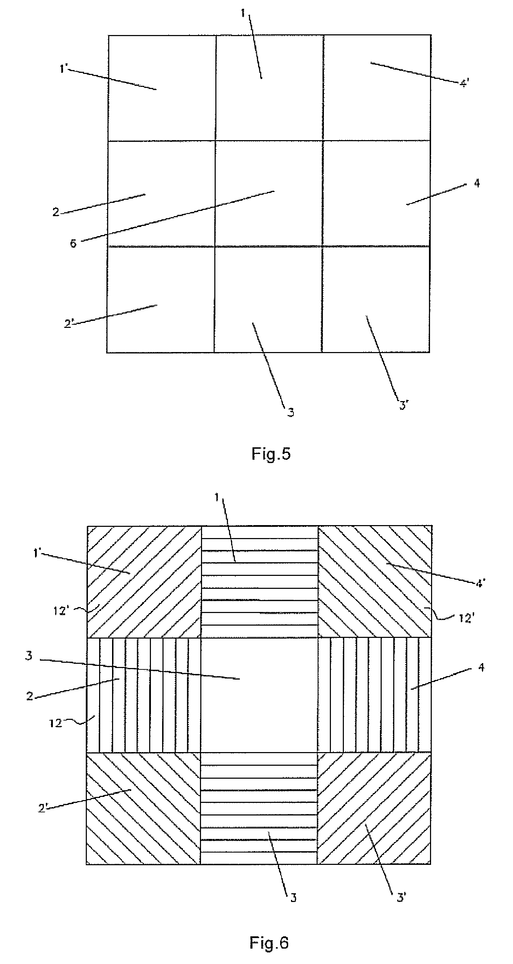

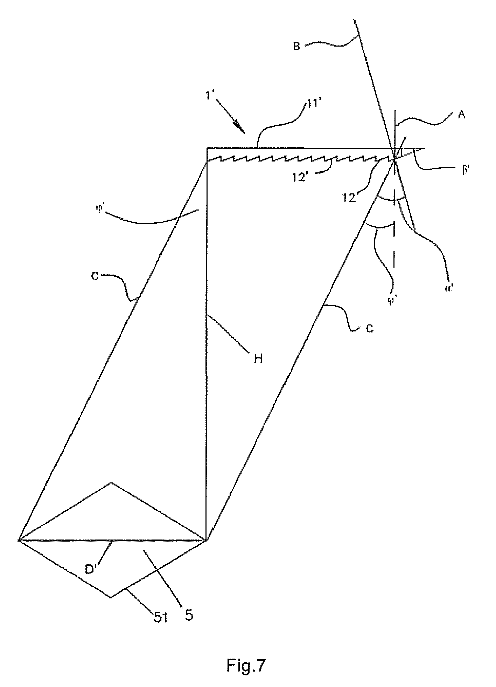

Figures 5, 6 and 7 show another embodiment of the present invention. As shown in figures 5, 6 and 7, this embodiment comprises eight lens, including lens 1, 1', 2, 2', 3, 3', 4, 4', the prisms of the adjacent lens are arranged at 135 degree. In this embodiment, the sides of the lens 1, 2, 3, 4 are equal in length to those of the light transmitting window 6 and connected thereto, the vertexes of the lens 1', 2', 3', 4' are connected to those of the light transmitting window 6. This embodiment can achieve a condensing efficiency of nine times, and the condensing principle is the same as that in the first embodiment, which will not be described again. In this embodiment, using the condensing lens 1' whose vertex is connected with that of light transmitting window 6 as the reference (as shown in figure 7), the distance H between the condensing lens 1' and the light receiving surface 5 meets the equation below: $H = \sqrt{2}L/_{tg(\alpha'-\beta')}$, *wherein,* $\alpha'$ is the refraction angle, $\beta'$ is the included angle between the light transmitting plane 11' of the condensing lens 4' and the refractive surface 12', and $\beta'$ and $\alpha'$ follow the relation: $n\sin\beta' = \sin\alpha'$. In figure 7, since both the condensing lens 1' and the light receiving surface 5 are square, the diagonal line of the condensing lens 1' has an equal length to the length D' of the diagonal line of the light receiving surface 5, namely, $D'=\sqrt{2}L$. So it can be derived from $tg(\alpha'-\beta') = D':H$ that $H = \sqrt{2}L/_{tg(\alpha'-\beta')}$.

In addition, the number of the lens may be three and they may be distributed in an arbitrary combination manner relative to the light transmitting window 6, for example, lens 1, 1', 2; lens 1, 1', 2'; lens 1, 1', 3; or lens 1, 1', 3', etc., shown in figures 6 and 7. The number of the lens may also be five and they may be distributed in an arbitrary combination manner relative to the light transmitting window 6, for example, lens 1, 2, 3, 4, 4' or 1, 1', 2', 3, 3', etc., shown in figures 6 and 7. The number of the lens may be six and they may be distributed in an arbitrary combination manner relative to the light transmitting window 6, for example, lens 1, 1', 2, 3, 3', 4 or 2, 2', 3, 1, 4', 4, etc., shown in figures 6 and 7. The number of the lens may be seven and they may be distributed in an arbitrary combination manner relative to the light transmitting window 6, for example, one condensing lens shown in figures 6 and 7 may be randomly removed.

Two specific embodiments of the present invention have been described above and they are not intended to limit the present invention in any manner. The skilled person in the art may make an equivalent embodiment by partial modification according to the spirit and disclosure of the present invention, for example, by arbitrarily increasing or decreasing the number of the lens, such an equivalent is still in the scope of the present invention.

## Claims

1. A solar concentration device includes a bracket, wherein, further also includes a light transmitting window, at least two condensing lenses which are arranged on the bracket and distributed around the light transmitting window, a light receiving surface which placed in parallel with the light transmitting window;
   One surface of the condensing lens is a light transmitting plane, the other surface of the condensing lens comprises uniformly distributed refractive prisms, the refractive surfaces of which are in parallel with each other, and the light beam refracted by each refractive prism is uniformly irradiated on the light receiving surface.

2. The solar concentration device of claim 1, wherein, the included angle $\beta$ between the refractive surface of the refractive prism and the light transmiting plane, the refraction angle $\alpha$ and the refractive index n of the refractive prism has the following relation: $n\sin\beta = \sin\alpha$.

3. The solar concentration device of claim 1, wherein, the distance H between the condensing lens and the light receiving surface and the side length L of the light receiving surface meet the following equation: $H = L/tg(\alpha-\beta)$, in which $\alpha$ is the refraction angle of the refractive prism, $\beta$ is the included angle between the refractive surface and the light transmitting plane.

4. The solar concentration device of claim 1, wherein, the distance H between the condensing lens and the light receiving surface and the side length L of the light receiving surface meet the following equation: $H = \sqrt{2}L/_{tg(\alpha'-\beta')}$, in which $\alpha'$ is the refraction angle of the refractive prism, $\beta'$ is the included angle between the refractive surface of the refractive prism and the light transmitting plane.

Fig.1

Fig.2

6

Fig.3

Fig.4

Fig.5

Fig.6

Fig.7

# INTERNATIONAL SEARCH REPORT

| International application No. |
|---|
| PCT/CN2009/001023 |

**A. CLASSIFICATION OF SUBJECT MATTER**

See extra sheet

According to International Patent Classification (IPC) or to both national classification and IPC

**B. FIELDS SEARCHED**

Minimum documentation searched (classification system followed by classification symbols)

IPC: G02B3, G02B19, H02N6, H01L31, F24J

Documentation searched other than minimum documentation to the extent that such documents are included in the fields searched

Electronic data base consulted during the international search (name of data base and, where practicable, search terms used)

CNPAT, WPI, EPODOC, (SUN, SOLAR, DAYLIGHT), (FRESNEL, PRISM, SAWTOOTH, SAWTEETH, ZIGZAG, SAW TOOTH, SAW TEETH)

**C. DOCUMENTS CONSIDERED TO BE RELEVANT**

| Category* | Citation of document, with indication, where appropriate, of the relevant passages | Relevant to claim No. |
|---|---|---|
| X | CN1971948A(TAIHAN TECHREN CO LTD) 30 May 2007(30.05.2007) page 3, last paragraph- page 5, line 12, figs.1-3, 5 | 1-4 |
| X | US2009/0225423A1(GWANGJU INSTITUTE OF SCIENCE AND TECHNOLOGY) 10 Sept.2009(10.09.2009) paragraphs [0003], [0005], [0026]-[0047], figs.1,3,4 | 1-4 |
| X | CN101170291A(SHI, Guoqing) 30 Apr.2008(30.04.2008) the embodiment part in description, figs.1,2 | 1-4 |
| X | CN101169287A(SHI, Guoqing) 30 Apr.2008(30.04.2008) the embodiment part in description, figs.1,2 | 1-4 |

☒ Further documents are listed in the continuation of Box C.    ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
|---|---|
| 04 May 2010(04.05.2010) | **03 Jun. 2010 (03.06.2010)** |

| Name and mailing address of the ISA/CN The State Intellectual Property Office, the P.R.China 6 Xitucheng Rd., Jimen Bridge, Haidian District, Beijing, China 100088 Facsimile No. 86-10-62019451 | Authorized officer **HU,Yan** Telephone No. (86-10)62085771 |
|---|---|

Form PCT/ISA /210 (second sheet) (July 2009)

## INTERNATIONAL SEARCH REPORT

| International application No. |
| --- |
| PCT/CN2009/001023 |

C (Continuation).      DOCUMENTS CONSIDERED TO BE RELEVANT

| Category* | Citation of document, with indication, where appropriate, of the relevant passages | Relevant to claim No. |
| --- | --- | --- |
| X | CN101169510A(SHI, Guoliang) 30 Apr.2008(30.04.2008)<br><br>the embodiment part in description, figs.1,2 | 1-4 |
| X | CN2738397Y(LIU, Bingheng) 02 Nov.2005(02.11.2005) pages 1,2, fig.1 | 1-4 |
| X | CN2929968Y(SUN, Yingguang) 01Aug.2007(01.08.2007) page 1, figs.1-4 | 1-4 |
| X | JP57-120902A(HORIGUCHI MASAO) 28 Jul.1982(28.07.1982)<br><br>page 1, lower right column, line 2- page 2, lower right column, last line, figs.1-5 | 1-4 |
| X | JP55-60154A(BABCOCK HITACHI KK) 07 May 1980(07.05.1980)<br><br>column 2, line 6-column 7, line 20, fig.2 | 1-4 |

Form PCT/ISA /210 (continuation of second sheet ) (July 2009)

**INTERNATIONAL SEARCH REPORT**
Information on patent family members

| International application No. |
| --- |
| PCT/CN2009/001023 |

| Patent Documents referred in the Report | Publication Date | Patent Family | Publication Date |
| --- | --- | --- | --- |
| CN1971948A | 30.05.2007 | US2007113883A1 | 24.05.2007 |
| | | DE102006035168A1 | 06.06.2007 |
| US2009/0225423A1 | 10.09.2009 | KR20090095775A | 10.09.2009 |
| | | JP2009217261A | 24.09.2009 |
| | | CN101576624A | 11.11.2009 |
| | | KR100934542B1 | 29.12.2009 |
| CN101170291A | 30.04.2008 | None | |
| CN101169287A | 30.04.2008 | None | |
| CN101169510A | 30.04.2008 | None | |
| CN2738397Y | 02.11.2005 | None | |
| CN2929968Y | 01.08.2007 | None | |
| JP57-120902A | 28.07.1982 | None | |
| JP55-60154A | 07.05.1980 | None | |

Form PCT/ISA /210 (patent family annex) (July 2009)

# INTERNATIONAL SEARCH REPORT

International application No.

PCT/CN2009/001023

**A. CLASSIFICATION OF SUBJECT MATTER**

G02B19/00 (2006.01) i

G02B 3/08 (2006.01) i

H02N 6/00 (2006.01) i

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN ZL200820057277
- CN 94112957

- CN 200610117470